# EUROPEAN PATENT APPLICATION

(11) **EP 2 211 369 A1**
(43) Date of publication of application: **28.07.2010**
(21) Application number: 09151239.2
(22) Date of filing: 23.01.2009
(51) Int. Cl.: H01J 37/32

(54) **Arrangement for working substrates by means of plasma**

(71) Applicant: Applied Materials, Inc., Santa Clara, CA 95054 (US)
(72) Inventor: Hein, Stefan, 63825, Blankenbach (DE); Herzog, Andre, 63755, Alzenau (DE); Morrison, Neil, 63654, Büdingen (DE); Kudela, Jozef, 94085, Sunnyvale (US)
(74) Representative: Schickedanz, Willi

(57) **Abstract**

The invention relates to an arrangement for working substrates by means of plasma (PECVD), wherein at least two electrodes (2, 3) are provided which are located in a common plane and are spaced apart from one another. Between the particular electrodes (2, 3) are provided interspaces (14, 15, 16) which serve as gas inlets or gas outlets.

## Description

The invention relates to an arrangement according to the preamble of patent claim 1.

Plasma enhanced chemical vapor deposition (Plasma Enhanced Chemical Vapor Deposition = PECVD) is a special form of chemical vapor deposition = CVD), in which the deposition of thin layers is enhanced through chemical reaction by means of CVD. Instead of the thermal activation in CVD, the surface reaction is regulated or highly modified via the plasma properties (Liebermann and Lichtenberg: Principles of Plasma Discharges and Materials Processing, 2nd Edition, 2005, p. 621 ff.). The plasma can burn directly at the substrate to be coated or in a separate chamber. In the first case, the method is referred to as direct plasma method, in the second case as remote plasma method.

In the direct plasma method between the substrate and a counterelectrode a strong electric field is applied, through which a plasma is ignited. The plasma causes the opening of the bonds of a reaction gas, for example SiH₄, and decomposes it into radicals which are deposited on the substrate and cause here the chemical deposition reaction. A higher deposition rate at lower deposition temperatures, for example 200 - 300 °C, than with the CVD method can thereby be attained.

In the remote plasma method the plasma is so disposed that it has no direct contact with the substrate. It is hereby possible to excite selectively individual components of a process gas mixture. The probability of damage of the substrate surface through the plasma is, moreover, low. Of disadvantage are the possible loss of radicals on the path between the remote plasma and the substrate; in addition, gas phase reactions can already occur before the reactive gas molecules reach the substrate surface.

PECVD plasmas can also be generated inductively or capacitively through the irradiation of alternating electric fields, making electrodes superfluous.

The PECVD method is applied in the semiconductor production and also in the production of solar cells or capacitors. Gases to be considered for use in plasma processes are, for example N₂O, NH₃, N₂, SiH₄ or other silanes. If there is the wish to produce, for example SiO₂ layers by means of hexamethyldisiloxane = HMDSO = C₆H₁₈O₂Si₂, a mixture of HMDSO, oxygen and perhaps an inert gas as excitation gas is introduced into a reaction chamber. The plasma subsequently breaks down the HMDSO molecules into their components, and substantially H₂O, CO₂ and SiO₂, however also byproducts, are produced in the reaction. Only the SiO₂ fraction contributes to the formation of the layer. The volatile or gaseous molecules, such as for example water and carbon dioxide, are pumped off.

An arrangement for the generation of plasma is already known, which includes two first electrodes connected to a voltage source and two grounded electrodes, with the first of the two grounded electrodes located in front of the first of the other electrodes and the first of the other electrodes disposed in front of the second grounded electrode (EP 1 475 824 A1). A first passage between a central first electrode permits the inlet of raw gas (first gas) which serves for the formation of a film on a substrate. A plasma discharge space of a second passage is provided between the first and second electrode, and specifically on both sides, whereby the excitable gas (second gas) can pass through. The raw gas can subsequently form a film, while the excitable gas itself is only excited and not utilized for the formation of a film.

An arrangement for the deposition of a substance out of the gas phase onto a substrate is furthermore disclosed (JP 2002-158219). This arrangement comprises several electrodes and between the electrodes two gas inlet channels and two gas outlet channels are provided.

A system for the working of substrates by means of plasma is furthermore known, with which the occurrence of flash-overs between an electrode in a dielectric is to be prevented (EP 1 796 442 A1). This system includes two working units, between which a gap is formed through which process gas is conducted.

Furthermore is known a PECVD installation with which photovoltaic materials can be applied onto a substrate (US 2006/0219170 A1). This installation includes a cathode with two opposing surfaces, with a system distributing a process gas being integrated in the electrode.

Lastly, a plasma working arrangement is also known with which a substrate can be worked effectively (JP 2005-026062). In this arrangement a substrate is transported parallel to three successively disposed electrodes. Between the electrodes gas supply means and gas drainage means are provided. Two of the electrodes are connected to a common voltage source.

The invention addresses the problem of providing a cost-effective arrangement for a PECVD working method.

This problem is solved according to the features of claim 1.

The invention relates thus to an arrangement for the working of substrates by means of plasma (PECVD), wherein at least two electrodes are provided, which are disposed in a common plane and are spaced apart from one another. Between each of the electrodes are provided interspaces which serve as gas inlets or gas outlets.

The advantage attained with the invention comprises in particular that an arrangement with several electrodes is provided, which has a small overall size since it is not necessary to provide each electrode with its own plasma source.

Embodiment examples of the invention are shown in the drawing and will be described in further detail in the following. In the drawing depict:
- Fig. 1: a schematic diagram of a first PECVD source with two electrodes,
- Fig. 2: a schematic diagram of a second PECVD source with two electrodes,
- Fig. 3: an enlarged diagram of a PECVD source corresponding to the PECVD source shown in Fig. 1,
- Fig. 4: a perspective diagram of parts of the PECVD source according to Fig. 3,
- Fig. 5: a source flange viewed from the atmospheric side,
- Fig. 6: the source flange according to Fig. 5, viewed from the vacuum side,
- Fig. 7: an adapter flange.

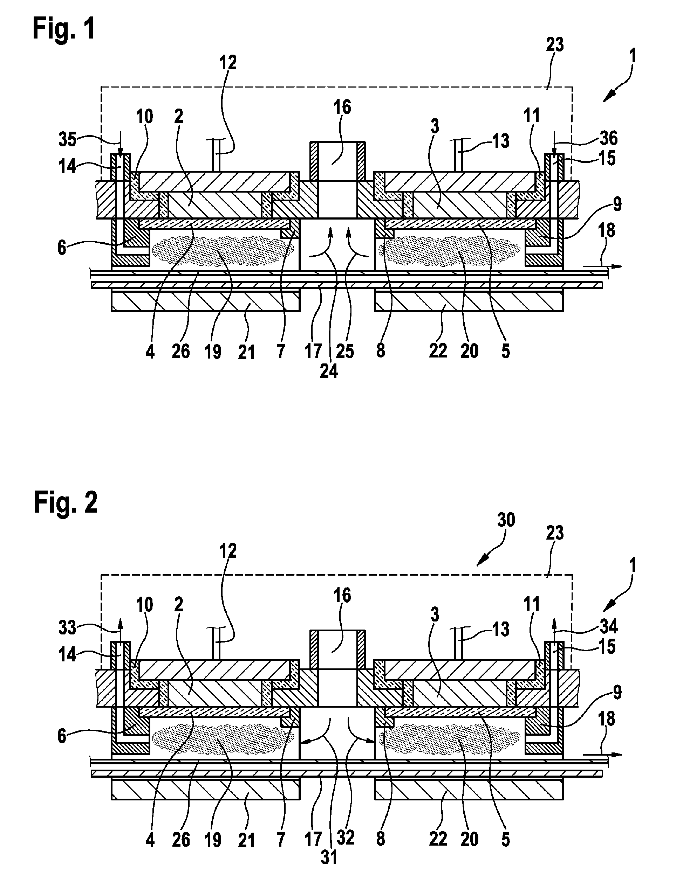

Fig. 1 shows a plasma chamber 1 in cross section, which includes two electrodes 2, 3 having the form of a T in cross section and being disposed in a common plane. On the underside of these electrodes 2, 3 are provided quartz plates 4, 5 supported by bearing supports 6, 7 and 8, 9, respectively. Electrical connections 12, 13 lead to voltage sources not shown, which can be AC voltage sources with a frequency greater than 1 kHz. Preferably both electrodes 2, 3 are connected to a common voltage source. At the particular opposite ends of the electrodes 2, 3 gas inlets 14, 15 are provided, while between the opposing ends of electrodes 2, 3 a gas outlet 16 is provided. The gas inflow direction is herein indicated by arrows 35, 36, while the gas outflow direction is symbolized by arrows 24, 25.

Below the quartz plates 4, 5 is depicted a counterelectrode 17. Above the counterelectrode 17 is located a substrate 26 which is transported in the direction of arrow 18. Between the quartz plates 4, 5 and the substrate 26 can be seen plasma clouds 19, 20, and beneath the counterelectrode 17 optionally heating elements 21, 22 are provided, which ensure a temperature-controlled counterelectrode 17. A matched housing 23 encompassing the two electrodes 2, 3 on the atmospheric side is indicated by means of dashed lines. Outside and underneath this housing 23 atmospheric pressure obtains, while beneath the quartz plates 4, 5 and the heating elements 21, 22 vacuum obtains. The housing 23 serves for high-frequency radiation shielding and as a contact guard against energized structural parts.

By 10 and 11 are denoted insulators encompassing the T-shaped electrodes 2, 3.

Although only two electrodes are shown in Fig. 1, more than two electrodes can also be provided. Each of the connections 12, 13 can be connected to a separate voltage source; however, it is also feasible to connect both connections 12, 13 to a single voltage source.

Fig. 2 shows an arrangement 30 which largely conforms to arrangement 1. However, in contrast to the arrangement of Fig. 1, the gas inlets and gas outlets are interchanged in the arrangement of Fig 2. The reference number 16 now indicates the gas inlet, with arrows 31, 32 symbolizing the direction of gas flow, while the gas inlets 14, 15 according to Fig. 1 now serve as the gas outlets. Arrows 33, 34 indicate herein the direction of gas flows.

The quartz plates 4, 5 are of advantage in terms of processing technique particularly if higher current and power densities are utilized, for example in a □c-Si process. In particular when the discharge switches to the so-called "gamma regime", quartz plates 4, 5 are of advantage. In the case of an "alpha regime", i.e. at low voltage or power density, such as are characteristic of a-Si, the ionization is mainly localized in the plasma, such that the role of the quartz plates can be neglected. Instead of quartz plates 4, 5, plates of another electrically non-conducting material, for example plates of ceramic, can also be utilized.

With the aid of quartz plates 4, 5 is attained that the emission of secondary electrons due to the ion bombardment effects a local increase of the plasma density. A higher plasma density, which corresponds to a high plasma stream, leads to a reduction of the plasma voltage. The plasma-ground voltage regulates the energy with which the ions bombard the substrate, i.e. a higher plasma voltage corresponds to higher energy. During the settling of amorphous silicon at energies of > ∼15 eV electrical and optical defects form. If, due to the quartz plates, the ion energy is decreased, an improvement in the material quality results at a constant input power density. The transition from good electrical-optical a-Si:H quality, which is referred to as alpha-gamma transition, is in general observed at ∼15 eV, which in a PECVD installation can correspond to an electrode voltage of approximately 200 to 300 Volt. The use of quartz plates consequently makes possible a relative increase of the power and therewith of the coating rate. The quartz plates, moreover, isolate the expensive mechanical structural parts - the electrodes and the insulators - from the process volume proper, i.e. no chemical-thermal reaction takes place between the plasma and these components. Only the quartz-glass sheets are directly exposed to this process. However, if necessary, they can be readily exchanged. These are furthermore of great advantage, for example during a plasma cleaning etching by means of NF₃, since here the quartz glass can additionally play out its excellent resistance properties. Added to this is the fact that during the process atomic components are knocked out of the source itself, i.e. a sputtering or disintegration process occurs. These atomic components are consequently also incorporated in the generated layers on the substrate. If this substrate is an electrically conducting material, this leads, for example in the production of a solar cell active layer, to the result that microscopically small shortcircuits form which, in turn, can have a negative effect on the efficiency of the finished solar cell. By applying the quartz plates, the major portion of the metallic source surface is covered such that the sputter effect is mainly limited to atomic quartz particles. Since quartz is an insulator, this does not present a problem for most applications.

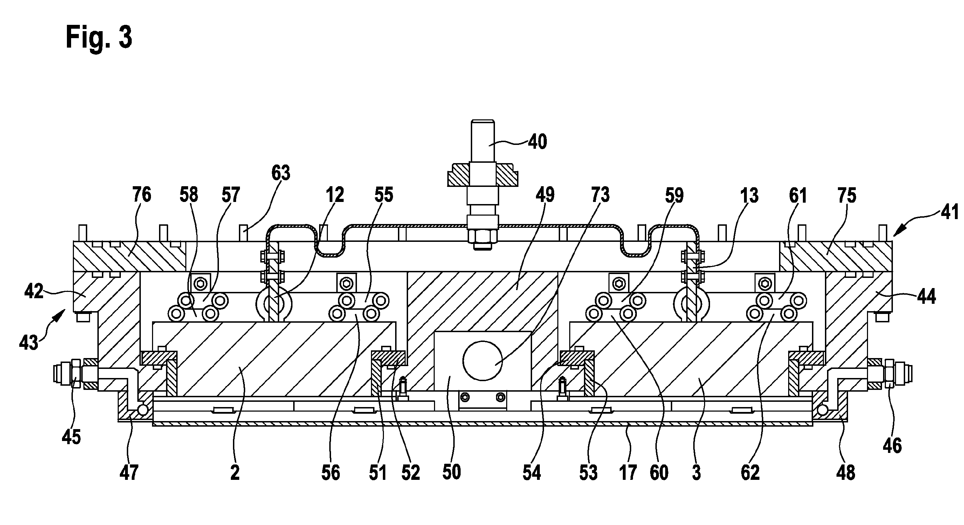

Fig. 3 shows an enlarged and modified diagram of the PECVD source depicted in Fig. 1. The substrate 26 and the heating elements 21, 22 are here omitted. Evident are again the electrodes 2 and 3 as well as the connections 12 and 13, which are here combined on a common electrical connector. Beneath the electrodes 2, 3 is evident the counterelectrode 17.

By 40 is denoted a power connector bolt, which leads to a, not shown, matching network. An adapter flange 41 rests on a source flange 43, which terminates in a VCR threaded connector 45, 46 for a gas pipework. Of this adapter flange 41 only lateral regions 75, 76 are evident. On each side a gas supply bar 47, 48 is provided which is provided over its entire length with holes or slits or nozzles, through which process gases are introduced. Through the appropriate distances of these holes with respect to one another and through appropriate cross sections of the holes a mixed gas distribution in the plasma volume is attained. The holes extend into the plane of drawing of Fig. 3 and are therefore not visible.

The source flange 43 includes a central region 49 as well as two lateral regions 42, 44. In this source flange 43 is provided a gas outlet channel 50 which can be provided at the suction side, for example, with DN40 ISO-KF connectors. Such a connector 73 is evident in Fig. 3. Circumferentially encompassing insulators 51 to 54 represent an electric insulation between the electrodes 2, 3 and the source flange 43. The insulators 51 to 54 herein do not encompass the upper portion of the T-shaped electrode 2, 3.

On the left electrode 2 is disposed a cooling water return flow tube 56, 58 implemented as a hose assembly, as well as a cooling water forward flow tube 55, 57, also implemented as a hose assembly. Above the second electrode 3 are correspondingly disposed a cooling water forward flow tube 59, 61 on a cooling water return flow tube 60, 62. The cooling water serves for the temperature control of the electrode bodies.

Into the adapter flange 41 lead several securement bolts, of which one is provided with the reference number 63.

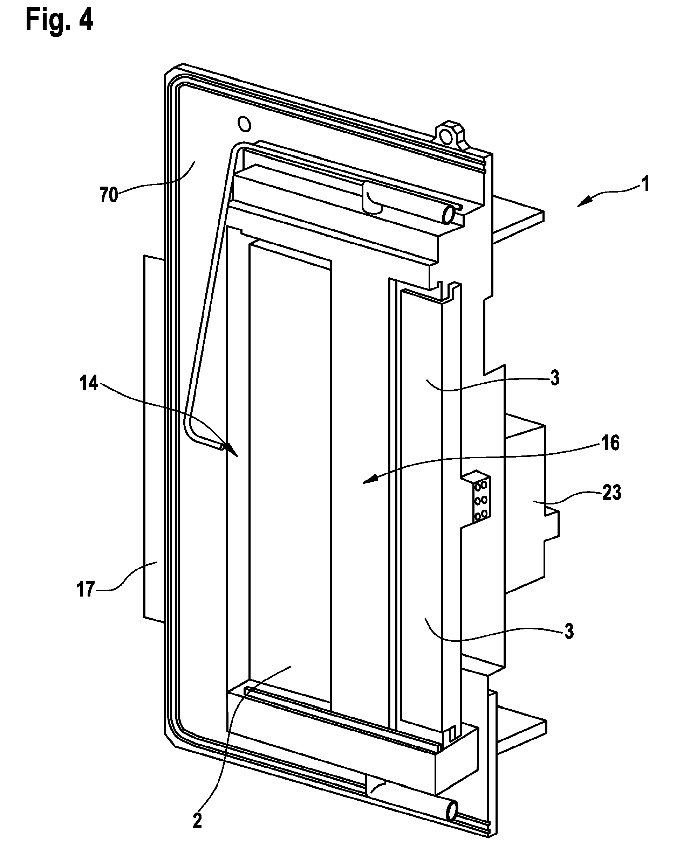

Fig. 4 shows the arrangement according to Fig. 1 in a perspective diagram. Evident are here the housing 23 enclosing a voltage source or a matching network, a door 70 to the arrangement 1, the electrodes 2, 3, the gas inlet 14, the gas outlet 16.

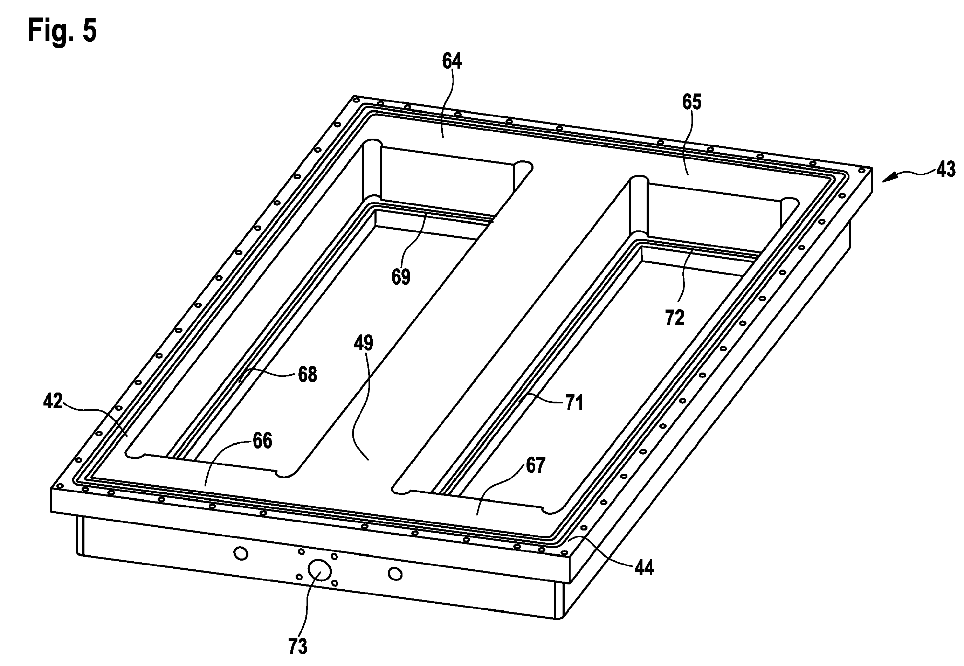

In Fig. 5 is depicted once again the source flange 43 shown in Fig. 3 in a view from the atmospheric side. Evident is here the central region 49 of the source flange 43 as well as its two outer regions 42 and 44, wherein all regions are connected with one another via webs 64 to 67. Projections 68, 69, 71, 72 are provided at the lower margins of the source flange 43. At the lower end of the central region 49 can be seen the suction-side connector 73 of gas outlet channel 50.

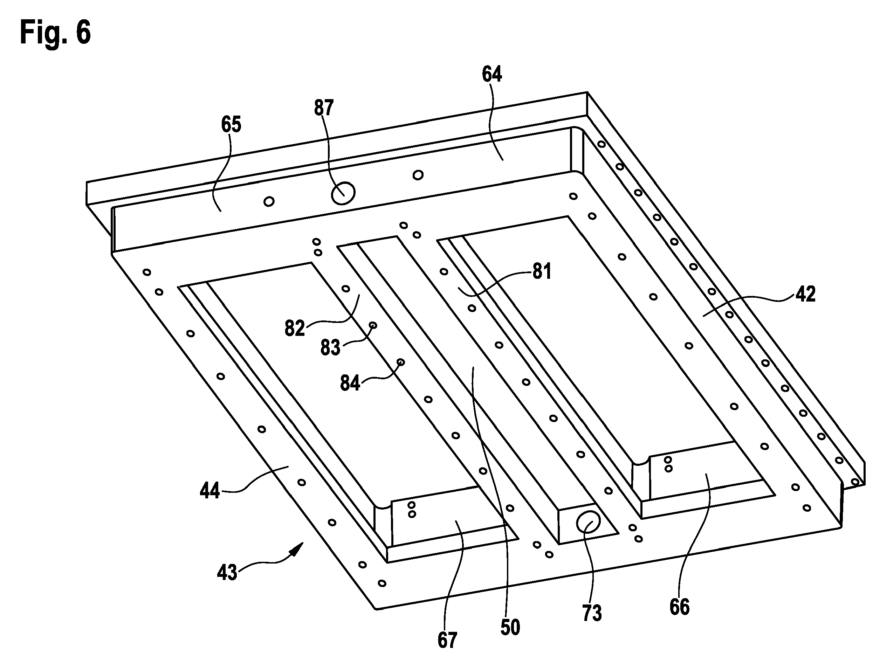

Fig. 6 shows the same source flange 43 as Fig. 4, however viewed from the vacuum side. Evident is here that the gas outlet channel 50 is encompassed by two webs 81, 82. At both ends of the U-shaped gas outlet channel 50 two suction-side connectors 73, 87 are visible to which lines connected to a vacuum pump, can be connected. A vacuum pump as well as the lines are not shown in Fig. 6.

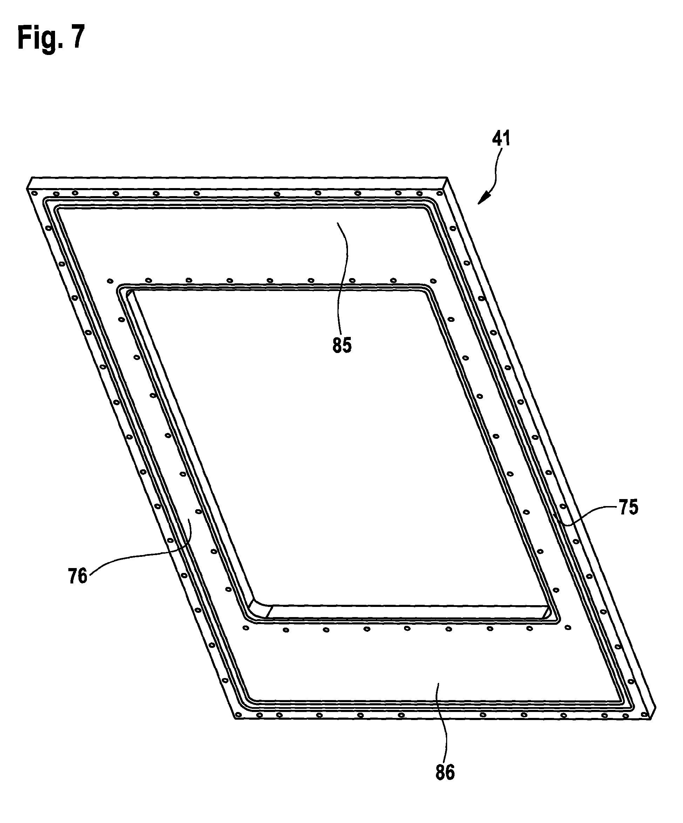

Fig. 7 shows the adapter flange 41 depicted in Fig. 3 in a view from the atmospheric side. This adapter flange 41 is also denoted as spacer flange 41. Evident are here the lateral regions 75 and 76 as well as the transverse regions 85, 86 connecting these. By variation of the thickness of this adapter flange 41 the size of the plasma volume, i.e. the region between electrodes or quartz glass plates and counterelectrode can, *inter alia*, be varied whereby a direct effect can be exerted onto the plasma density and onto the process.

Those skilled in the art can readily recognize that numerous variations and substitutions may be made in the invention, its use and its configuration to achieve substantially the same results as achieved by the embodiments described herein. Accordingly, there is no intention to limit the invention to the disclosed exemplary forms. Many variations, modifications and alternative constructions fall within the scope and spirit of the disclosed invention as expressed in the claims.

### List of Reference Numbers

- 1: Plasma chamber
- 2: Electrode
- 3: Electrode
- 4: Quartz plate / dielectric plate
- 5: Quartz plate / dielectric plate
- 6: Bearing support
- 7: Bearing support
- 8: Bearing support
- 9: Bearing support
- 10: Insulator
- 11: Insulator
- 12: Electric connection
- 13: Electric connection
- 14: Gas inlet / gas outlet
- 15: Gas inlet / gas outlet
- 16: Gas outlet / gas inlet
- 17: Counterelectrode
- 18: Arrow
- 19: Plasma cloud
- 20: Plasma cloud
- 21: Heating element
- 22: Heating element
- 23: Housing
- 24: Arrow
- 25: Arrow
- 26: Substrate

- 30: Arrangement
- 31: Arrow
- 32: Arrow
- 33: Arrow
- 34: Arrow
- 35: Arrow
- 36: Arrow

- 40: Power connector bolt
- 41: Adapter flange
- 42: Lateral region
- 43: Source flange
- 44: Lateral region
- 45: VCR threaded connector
- 46: VCR threaded connector
- 47: Gas supply bar
- 48: Gas supply bar
- 49: Central region

- 50: Gas outlet channel
- 51: Insulator
- 52: Insulator
- 53: Insulator
- 54: Insulator
- 55: Cooling water forward flow tube
- 56: Cooling water return flow tube
- 57: Cooling water forward flow tube
- 58: Cooling water return flow tube
- 59: Cooling water forward flow tube

- 60: Cooling water return flow tube
- 61: Cooling water forward flow tube
- 62: Cooling water return flow tube
- 63: Securement bolt
- 64: Web
- 65: Web
- 66: Web
- 67: Web
- 68: Projection
- 69: Projection

- 70: Door
- 71: Projection
- 72: Projection
- 73: Connector
- 74:
- 75: Lateral region
- 76: Lateral region

- 81: Web
- 82: Web
- 83:
- 84:
- 85: Transverse region
- 86: Transverse region
- 87: Connector

## Claims

1. Arrangement for the working of substrates (26) by means of plasma (19, 20), wherein several electrodes (2, 3) are provided spaced apart from one another, and wherein at least one process gas is introduced into the arrangement, **characterized in that** for the inlet or outlet (14, 15; 16) of the process gas interspaces between the electrodes (2, 3) are provided.

2. Arrangement as claimed in claim 1, **characterized in that** the electrodes (2, 3) are disposed in a common plane.

3. Arrangement as claimed in claim 1, **characterized in that** in the presence of two electrodes (2, 3) the interspace between the two electrodes (2, 3) serves as the gas inlet or the gas outlet (16), while the gas outlet or gas inlet (14, 15) is provided at the ends of the electrodes (2, 3) remote from one another.

4. Arrangement as claimed in claim 1, **characterized in that** the electrodes (2, 3) in cross section have the form of a T.

5. Arrangement as claimed in claim 1, **characterized in that** the electrodes (2, 3) are connected across lines (12, 13) to a common voltage source.

6. Arrangement as claimed in claim 1, **characterized in that** on the underside of the electrodes (2, 3) a dielectric plate (4, 5) is provided.

7. Arrangement as claimed in claim 6, **characterized in that** the dielectric plate (4, 5) is comprised of quartz.

8. Arrangement as claimed in claim 1, **characterized in that** the electrodes (2, 3) are encompassed on at least portions of their periphery by one insulator (10, 11) each.

9. Arrangement as claimed in claim 8, **characterized in that** the particular insulators (10, 11) rest on a support.

10. Arrangement as claimed in claim 1, **characterized in that** opposite the electrodes (2, 3) is disposed a common counterelectrode (17).

11. Arrangement as claimed in claim 10, **characterized in that** between the electrodes (2, 3) and the counterelectrode (17) is provided the substrate (26).

12. Arrangement as claimed in claim 1, **characterized in that** above the electrodes (2, 3) cooling means (57 - 60) are provided for the temperature control of these electrodes (2, 3).

13. Arrangement as claimed in claim 12, **characterized in that** the cooling means (57 - 60) are cooling agent forward flow tubes or cooling agent return flow tubes.

14. Arrangement as claimed in claim 1, **characterized in that** an adapter flange (41) is provided, with which the size of the plasma volume can be varied.
